Europäisches Patentamt

European Patent Office

Office européen des brevets

(11) Veröffentlichungsnummer: 0 341 463
A1

## EUROPÄISCHE PATENTANMELDUNG

(21) Anmeldenummer: 89107151.6

(51) Int. Cl.⁴: H03M 7/22

(22) Anmeldetag: 20.04.89

(30) Priorität: 11.05.88 DE 3816236

(43) Veröffentlichungstag der Anmeldung:
15.11.89 Patentblatt 89/46

(84) Benannte Vertragsstaaten:
DE FR GB IT NL

(71) Anmelder: Siemens Aktiengesellschaft
Wittelsbacherplatz 2
D-8000 München 2(DE)

(72) Erfinder: Wilhelm, Wilhelm, Dr. Ing.
Geigenbergerstrasse 23
D-8000 München 71(DE)
Erfinder: Würtele, Johann, Dipl.-Ing.
Dom-Pedrostrasse 44
D-8000 München 19(DE)

(54) Einstufiger Decodierer mit Speicher in Bipolartechnik.

(57) Einstufiger Decodierer in Bipolartechnik zur Umwandlung eines n-stelligen Dualcode-Wortes in einen 1 aus $2^n$ Code mit zusätzlicher Speicherung, bestehend aus $2^n$ Emitterfolgen (TE1...TEn), welche abhängig von n seriell liegenden Differenzverstärkern (TS11,TS12...TSn1,TSn2) entweder durch n Differenzverstärker (T11,T12...Tn1,Tn2) mit n Eingängen (E1...En) oder durch n parallel geschaltete, kreuzgekoppelte Differenzverstärker (TP11, TP12...TPn1,TPn2) über ein Diodennetzwerk angesteuert werden.

## Einstufiger Decodierer mit Speicher in Bipolartechnik

Die Erfindung bezieht sich auf einen Decodierer nach dem Oberbegriff des Patentanspruches.

Bei Schaltnetzen, die aus mehreren in Reihe geschalteten Gatterstufen aufgebaut sind, nehmen im allgemeinen die Signallaufzeit und die Verlustleistung mit steigender Stufenzahl zu. Ein in üblicher Schaltungstechnik realisiertes Schaltnetz, das eine Decodierung verbunden mit einer Speicherung durchführt, benötigt daher mehrere Stufen, da die Decodier- und Speicherelemente häufig selbst aus mehreren Stufen aufgebaut sind. Aus der deutschen Patentschrift 25 34 736 ist zwar ein Decodierer bekannt, der lediglich einstufig ausgeführt ist, für eine Speicherung ist aber dennoch mindestens eine weitere Stufe erforderlich.

Der Erfindung liegt demgemäß die Aufgabe zugrunde, einen Decodierer zur Umwandlung eines n-stelligen Dualcode-Wortes in einen 1 aus $2^n$ Code mit zusätzlicher Speicherfunktion anzugeben, der im wesentlichen einstufig aufgebaut ist.

Die Aufgabe wird bei einem gattungsgemäßen Decodierer durch die kennzeichnenden Merkmale des Patentanspruches gelöst.

Der Vorteil liegt erfindungsgemäß darin, daß der Decodierer neben der geringen Signallaufzeit und der niedrigen Verlustleistung auch weniger Bauelemente als bekannte Ausführungen benötigt. Er ist daher für die Verwendung in integrierten Bausteinen mit hohem Integrationsgrad sehr gut geeignet.

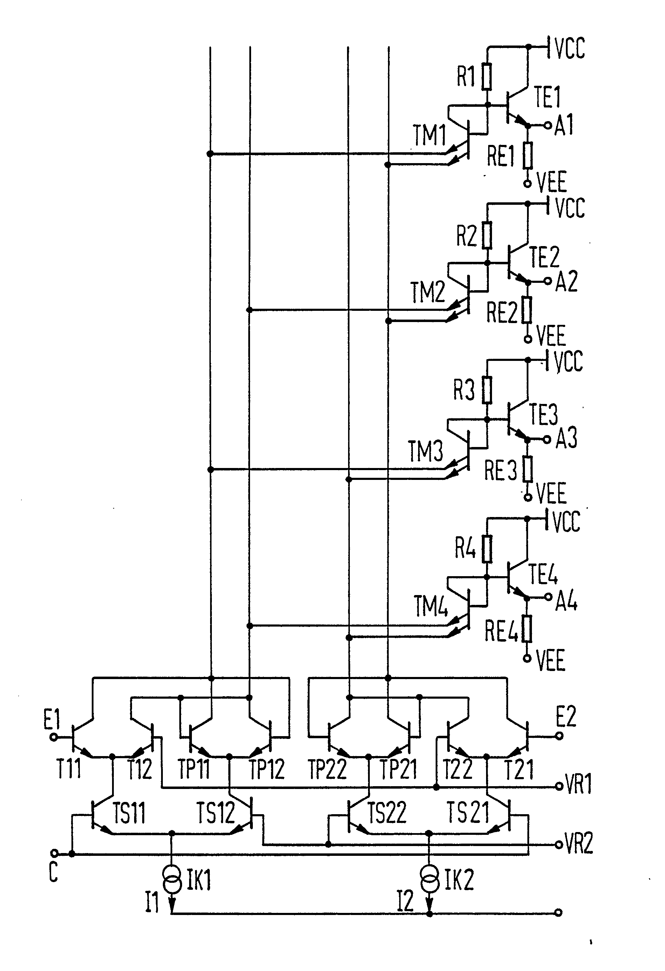

Ein Ausführungsbeispiel der Erfindung ist in der Zeichnung dargestellt und wird im folgenden näher beschrieben.

Die Zeichnung zeigt eine Ausführungsform zur Umwandlung eines zweistelligen Dualcode-Wortes in einen 1 aus 4 Code mit zusätzlicher Speichermöglichkeit. Entsprechend den zwei Dualstellen des umzuwandelnden Wortes sind zwei Decodier-Differenzverstärker mit den Steuereingängen E1 und E2 vorgesehen. Die Differenzverstärker enthalten die paarweise emittergekoppelten Transistoren T11 und T12, T21 und T22. Die Basen der nicht angesteuerten Transistoren T12,T22 der Decodier-Differenzverstärker liegen an einem gegebenen Hilfspotential VR1.

Die Kollektoren der Transistoren T12,T22 sind an je einen Emitter des Mehremittertransistors TM1 angeschlossen. Der Kollektor dieses Transistors ist mit seiner eigenen Basis, mit der Basis des Transistors TE1 in Emitterfolgerschaltung und mit dem Widerstand R1 verbunden, dessen anderes Ende an dem kollektorseitigen Pol VCC der nicht dargestellten Versorgungsspannungsquelle liegt. Der Emitter des Transistors TE1 führt zum Schaltungsausgang A1. Der Widerstand RE1 bildet den Emitterwiderstand des Emitterfolgers. Bekanntlich wird der Emitterwiderstand von Emitterfolgern am Ausgang von Verknüpfungsgliedern häufig weggelassen und durch einen gleichartigen äußeren Widerstand oder durch den Eingangswiderstand nachgeschalteter Verknüpfungsglieder ersetzt.

Die FIG zeigt noch drei weitere Schaltglieder der gleichen Art. Sie führen zu den Ausgängen A2,A3 und A4. Die Emitter der Mehremittertransistoren der weiteren Schaltglieder sind ebenfalls mit den Kollektoren je eines Transistors der zwei Dekodier-Differenzverstärker, jedoch jeweils in anderer Weise, verbunden. Die Wahl der Verbindungen zwischen den Emittern der Mehremittertransistoren aller Schaltglieder und den Ausgängen der Decodier-Differenzverstärker erfolgt unter Ausnutzung aller Kombinationsmöglichkeiten. Dabei dürfen jedoch niemals die Emitter eines Mehremittertransistors mit den Kollektoren von Transistoren verbunden werden, die gemeinsam einem Differenzverstärker angehören.

Die Kollektoren der beiden Decodier-Differenzverstärker T11,T12 und T21,T22 sind jeweils mit den entsprechenden Kollektoren der beiden parallelen Differenzverstärker TP11,TP12 und TP21,TP22 verschaltet, wobei die beiden Transistoren der parallelen Differenzverstärker über Kreuz jeweils zwischen Basis und Kollektor verbunden sind. Zwei weitere, serielle Differenzverstärker TS11,TS12 bzw. TS21,TS22 sind jeweils über den Kollektor des Eingangstransistors TS11 bzw. TS21 mit dem gemeinsamen Emitter des Transistorpaares T11,T12 bzw. T21,T22 und über den Kollektor des anderen Transistors TS12 bzw. TS22 mit dem gemeinsamen Emitter des Transistorpaares TP11,TP12 bzw. TP21,TP22 verbunden. Die Basen der Eingangstransistoren TS11 und TS21 der seriellen Differenzverstärker bilden gemeinsam den Eingang C und die Basen der anderen Transistoren TS12 und TS22 liegen zusammen an einem Hilfspotential VR2. Die Emitter der Transistorpaare TS11,TS12 und TS21,TS22 der seriellen Differenzverstärker sind über untereinander gleiche Konstantstromquellen IK1 und IK2 zur Lieferung der eingeprägten Ströme I1 und I2 mit dem emitterseitigen Pol VEE der Versorgungsspannungsquelle verbunden.

Bei allen Ziffernkombinationen des zweistelligen Dualcode-Wortes am Eingang des Decodierers führt einer und nur einer der vier Ausgänge einen der logischen "1" entsprechenden Signalpegel. Das ist beispielsweise bei der in der Zeichnung dargestellten Ausführungsform am Ausgang A1 der Fall, wenn am Eingang das Dualcode-Wort 11 steht. Bei den allen anderen Ausgängen zugeordneten Schaltgliedern fließt durch den Widerstand Rk (k = 1...m) ein Strom i, der so groß sein muß, daß i mal Rk dem Signalhub UH, d.h. der Differenz zwischen dem hohen und dem niederen Signalpegel gleich ist. Der Strom Ij der Konstantstromquelle IKJ (j = 1...n) muß daher so eingestellt werden, daß 2 . Ij für die Erzeugung der notwendigen Spannungsabfälle an drei Widerständen Rk ausreichen. Dabei sorgen die Diodenstrecken der Mehremittertransistoren für die gleichmäßige Aufteilung der beiden Ströme Ij auf die drei Widerstände Rk. Die betreffenden Ausgänge werden dann auf dem niederen Signalpegel (= logischen "0") gehalten.

Im allgemeinen gilt, daß nIj ausreichend sein müssen, um an $2^n$- 1 Widerständen Rk den dem Signalhub UH entsprechenden Spannungsabfall zu erzeugen. Die Ströme Ij der Konstantstromquellen IKj müssen daher $(2^n-1)/n$ UH/Rk gleich sein. Diese Bedingung läßt sich auch in der Form Ij Rk n/(m-1) = UH ausdrücken.

Bei einem einer logischen "1" entsprechendem Signalpegel am Takteingang C wird aufgrund der durchgeschalteten Eingangstransistoren TS11...TSn1 der seriellen Differenzverstärker der jeweilige Konstantstrom 11...In ausschließlich den n Decodier-Differenzverstärkern zugeführt und die Schaltung arbeitet in bekannter Weise als Decodierer ohne Speicherung. Durch Anlegen einer logischen "0" an den Takteingang C wird der Konstantstrom nun auf die jeweiligen, parallelen Differenzverstärker geleitet, welche aufgrund ihrer Kreuzkopplung Speicherelemente bilden und damit den Zustand an den gemeinsamen Kollektorleitungen aufrechterhalten. Eine Veränderung des Zustandes über die Eingänge E1... En ist deshalb nicht möglich, da die Decodier-Differenzverstärker ohne Konstantstromeinspeisung wirkungslos sind.

Die daraus resultierenden Vorteile liegen darin, daß die bei der Decodierung benötigten Stromquellen ebenso zur Speicherung mitbenutzt werden, wodurch sich eine Reduzierung des Bauteileaufwandes und des Leistungsbedarfes ergibt. Durch die Parallelschaltung von Decodiereinheit und Speichereinheit wird darüber hinaus eine Verringerung der Signallaufzeit erreicht

**Ansprüche**

1. Einstufiger Decodierer mit Speicher in Bipolartechnik mit n Eingängen und m = $2^n$ Ausgängen zur Umwandlung eines n-stelligen Dualcode-Wortes in einen 1 aus $2^n$ Code, derart aufgebaut, daß die n Eingänge (E1...En) mit den Basen der Eingangstransistoren (T11...Tn1) von n Decodier-Differenzverstärkern aus je zwei emittergekoppelten Transistoren (T11, T12...Tn1, Tn2) entsprechend verbunden sind, daß m Schaltglieder vorgesehen sind, die je einen Mehremittertransistor (TM1...TMm) mit n Emittern aufweisen, dessen Basis und Kollektor mit der Basis eines Transistors (TE1...TEM) in Emitterfolgerschaltung für die Ausgabe eines der m Ausgangssignale und über einen Widerstand (R1...Rm) mit dem kollektorseitigen Pol (VCC) einer Versorgungsspannungsquelle verbunden sind, daß die n Emitter der Mehremittertransistoren (TM1...TMm) an den Kollektor je eines Transistors (T11 bzw. T12...Tn1 bzw. Tn2) aller Decodier-Differenzverstärker in einer von Schaltglied zu Schaltglied verschiedenen Kombination angeschlossen sind, **dadurch gekennzeichnet**, daß die Kollektoren der Transistoren (T11,T12...Tn1,Tn2) der n Decodier-Differenzverstärker jeweils mit den Kollektoren der entsprechenden Transistoren (TP11,TP12...TPn1,TPn2) von n parallelen Differenzverstärkern aus je zwei emittergekoppelten Transistoren (TP11,TP12...TPn1,TPn2) und die beiden Transistoren eines jeden parallelen Differenzverstärkers miteinander über Kreuz jeweils zwischen Basis und Kollektor verbunden sind, daß ein weiterer Eingang (C) mit den Basen der Eingangstransistoren (TS11...TSn1) von n seriellen Differenzverstärkern aus je zwei emittergekoppelten Transistoren (TS11,TS12...TSn1,TSn2) mit Konstantstromeinspeisung verbunden ist, daß die Kollektoren der Eingangstransistoren (TS11...Tn1) der n seriellen Differenzverstärker jeweils an die Emitter der Transistoren (T11,T12... Tn1,Tn2) der entsprechenden Decodier-Differenzverstärker und die Kollektoren der anderen Transistoren (TS12...Tn2) der seriellen Differenzverstärker jeweils an die Emitter der Transistoren (TP11,TP12...TPn1,TPn2) der parallelen Differenzverstärker angeschlossen sind und daß die eingespeisten Konstantströme (I1 ...In) und die Werte der Widerstände (R1...Rm) so bemessen sind, daß das Produkt aus der Stromstärke und dem

$$\frac{n}{m - 1}$$

fachen Widerstandswert gleich der Differenz zwischen dem hohen und dem niederen Signalpegel ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | IBM TECHNICAL DISCLOSURE BULLETIN, Band 21, Nr. 6, November 1978, Seiten 2406-2407, New York, US; R.D. BURKE: "Cascode current switch, latched input, 2-bit partitioned decoder" * Figur; Seiten 2406-2407 * --- | 1 | H 03 M  7/22 |
| A | FR-A-2 409 640  (SIEMENS) ----- | 1 | |

RECHERCHIERTE SACHGEBIETE (Int. Cl.4)

H 03 M

Der vorliegende Recherchenbericht wurde für alle Patentansprüche erstellt

| Recherchenort | Abschlußdatum der Recherche | Prüfer |
|---|---|---|
| DEN HAAG | 18-08-1989 | FEUER F.S. |